# EUROPEAN PATENT APPLICATION

(11) **EP 4 501 621 A1**
(43) Date of publication of application: **05.02.2025**
(21) Application number: 22933619.3
(22) Date of filing: 14.11.2022
(51) Int. Cl.: B32B 9/00, B32B 37/20, C23C 16/42

(54) **LAMINATE AND METHOD FOR PRODUCING LAMINATE**

(30) Priority: 25.03.2022 JP 2022050807
(71) Applicant: FUJIFILM Corporation, Tokyo 106-8620 (JP)
(72) Inventor: MOCHIZUKI, Yoshihiko, ashigara-shi, Kanagawa 250-0193 (JP); NAGANO, Satoshi, ashigara-shi, Kanagawa 250-0193 (JP); HARASAWA, Takehiko, ashigara-shi, Kanagawa 250-0193 (JP); SEKI, Tomokazu, ashigara-shi, Kanagawa 250-0193 (JP)
(74) Representative: Meissner Bolte Partnerschaft mbB
(86) International application number: PCT/JP2022/042287
(87) International publication number: WO 2023/181489

(57) **Abstract**

Provided are a laminate including a first resin layer, an inorganic layer, and a second resin layer, in which a mixed layer is provided between the first resin layer and the inorganic layer and between the second resin layer and the inorganic layer; and a manufacturing method of a laminate.

## Description

### BACKGROUND OF THE INVENTION

### 1. Field of the Invention

The present disclosure relates to a laminate and a manufacturing method of a laminate.

### 2. Description of the Related Art

As a method of laminating laminates each including a substrate and an inorganic layer of a metal oxide or the like provided on a surface of the substrate, a method of activating a surface of the inorganic layer for bonding the laminates together is known.

For example, JP2019-119086A discloses a method in which a metal oxide film is formed on a surface of a substrate by sputtering to form a laminate, and the metal oxide films of two laminates are bonded together. According to the above method, since there is no need to use an adhesive or the like, the thickness of the resulting laminate can be reduced, and manufacturing costs can be reduced.

### SUMMARY OF THE INVENTION

Recently, the present inventors have newly found that although a laminate manufactured by the method disclosed in JP2019-119086A has excellent adhesiveness between metal oxide films, there is room for improvement in adhesiveness between a substrate and a metal oxide film.

An object to be achieved by one embodiment of the present disclosure is to provide a laminate having excellent adhesiveness between layers and a manufacturing method of a laminate.

The present disclosure includes the following aspects.
<1> A laminate comprising: a first resin layer; an inorganic layer; and a second resin layer, in which a mixed layer is provided between the first resin layer and the inorganic layer, and between the second resin layer and the inorganic layer.
<2> The laminate according to <1>, in which the inorganic layer is a continuous layer.
<3> The laminate according to <1> or <2>, in which the inorganic layer has a void ratio of 25% or less.
<4> The laminate according to any one of <1> to <3>, in which the mixed layer has a thickness of 1 nm to 30 nm.
<5> The laminate according to any one of <1> to <4>, in which the inorganic layer contains one or more inorganic materials selected from the group consisting of a silicon oxide, a silicon nitride, an aluminum oxide, and an aluminum nitride.
<6> The laminate according to any one of <1> to <5>, in which the inorganic layer contains silicon dioxide.
<7> The laminate according to any one of <1> to <6>, in which the inorganic layer has a thickness of 5 nm or less.
<8> A laminate comprising; a first resin layer; and a second resin layer, in which a contrast layer containing an inorganic material is provided between the first resin layer and the second resin layer, and in a case where a cross section of the laminate is irradiated with electron beams for 10 minutes under conditions of a voltage of 300 kV using a transmission electron microscope and a cross-sectional image of a test piece after the electron beams irradiation is obtained, a density measured by image analysis software decreases from an inside of the contrast layer of the cross-sectional image toward a surface.
<9> A manufacturing method of a laminate, comprising: a step of forming a mixed layer and an inorganic layer in this order on each surface of a first resin layer and a second resin layer by plasma chemical vapor deposition to obtain a first laminate including the first resin layer, the mixed layer, and the inorganic layer and a second laminate including the second resin layer, the mixed layer, and the inorganic layer; and a step of laminating the inorganic layer of the first laminate and the inorganic layer of the second laminate.
<10> The manufacturing method of a laminate according to <9>, in which the formation of the mixed layer and the inorganic layer on each of the first resin layer and the second resin layer and the lamination of the first laminate and the second laminate are carried out at the same time.
<11> The manufacturing method of a laminate according to <9> or <10>, in which the inorganic layer of the first laminate and the inorganic layer of the second laminate each has a surface roughness Ra of 2 nm or less.
<12> A manufacturing method of a laminate, comprising: a step of forming a contrast layer on each surface of a first resin layer and a second resin layer by plasma chemical vapor deposition to obtain a first laminate including the first resin layer and the contrast layer and a second laminate including the second resin layer and the contrast layer; and a step of laminating the contrast layer of the first laminate and the contrast layer of the second laminate.
<13> The manufacturing method of a laminate according to <9>, in which the formation of the contrast layer on each of the first resin layer and the second resin layer and the lamination of the first laminate and the second laminate are carried out at the same time.
<14> The manufacturing method of a laminate according to <9> or <10>, in which the contrast layer of the first laminate and the contrast layer of the second laminate each has a surface roughness Ra of 2 nm or less.

According to one embodiment of the present disclosure, it is possible to provide a laminate having excellent adhesiveness between layers and a manufacturing method of a laminate.

### BRIEF DESCRIPTION OF THE DRAWINGS

Fig. 1 is a schematic cross-sectional view showing one embodiment of a laminate according to a first embodiment.
Fig. 2 is a schematic cross-sectional view showing one embodiment of the laminate according to the first embodiment.
Fig. 3 is a schematic view showing one embodiment of a device that can be used for manufacturing the laminate according to the first embodiment and a laminate according to a second embodiment.
Fig. 4 is a schematic view showing one embodiment of a device that can be used for manufacturing the laminate according to the first embodiment and the laminate according to the second embodiment.
Fig. 5 is a schematic view showing one embodiment of a device that can be used for manufacturing the laminate according to the first embodiment and the laminate according to the second embodiment.

### DESCRIPTION OF THE PREFERRED EMBODIMENTS

Hereinafter, embodiments of the present disclosure will be described in detail. The present disclosure is not limited to the following embodiments. The following embodiments may be modified as appropriate within the scope of purpose of the present disclosure.

In the present disclosure, any numerical range indicated using "to" indicates a range that includes a numerical value described before "to" as a lower limit value and a numerical value described before "to" as an upper limit value. In any numerical range described in a stepwise manner in the present disclosure, an upper limit value or a lower limit value described in a certain numerical range may be replaced with an upper limit value or a lower limit value of another numerical range described in a stepwise manner. In addition, in any numerical range described in the present disclosure, an upper limit value or a lower limit value described in a certain numerical range may be replaced with values shown in Examples.

In the present disclosure, each component may contain a plurality of types of substances corresponding thereto. In a case where a plurality of types of substances corresponding to each component are present in a composition, a content percentage or content of each component is a total content percentage or total content of the plurality of types of substances present in the composition, unless otherwise specified.

In the present disclosure, the term "layer" or "film" is defined to include not only a case where the layer or film is formed in the entire region but also a case where the layer or film is formed only in a part of the region, upon observing a region in which the layer or film is present.

In the present disclosure, the term "laminating" indicates that layers are laminated, and two or more layers may be bonded or two or more layers may be attachable and detachable.

In the present disclosure, the term "(meth)acryloyl group" means at least one of an acryloyl group or a methacryloyl group, and the term "(meth)acrylic" means at least one of acrylic or methacrylic.

In the present disclosure, the term "step" includes not only an independent step but also a step that cannot be clearly distinguished from other steps in a case where the intended purpose is achieved.

In the present disclosure, the thickness of each layer is measured from a cross-sectional image obtained by a method of confirming the presence of a mixed layer which will be described later.

In the present disclosure, in a case where an embodiment is described with reference to the accompanying drawings, the configuration of the embodiment is not limited to the configuration shown in the drawings. In addition, the sizes of the members in each drawing are conceptual, and the relative size relationships between the members are not limited thereto.

### [Laminate according to first embodiment]

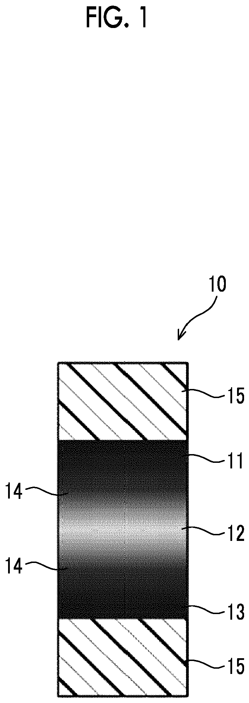

As shown in Fig. 1, a laminate 10 according to a first embodiment includes a first resin layer 11, an inorganic layer 12, and a second resin layer 13, and also includes a mixed layer 14 between the first resin layer 11 and the inorganic layer 12 and between the second resin layer 13 and the inorganic layer 12.

As shown in Fig. 1, the laminate 10 according to the first embodiment may include a support 15 on the outermost surface thereof.

The laminate according to the first embodiment has excellent adhesiveness between layers. The reason why the first laminate exhibits the above-described effect is not clear, but it is presumed as follows.

It is presumed that the laminate according to the first embodiment includes a mixed layer, in which materials constituting the first resin layer, the inorganic layer, and the second resin layer are mixed, between the first resin layer and the inorganic layer and between the second resin layer and the inorganic layer, and the mixed layer has excellent adhesiveness to the first resin layer and the inorganic layer as well as excellent adhesiveness to the second resin layer and the inorganic layer, so the adhesiveness between layers is improved.

It is preferable that the first resin layer, the mixed layer, the inorganic layer, the mixed layer, and the second resin layer included in the laminate according to the first embodiment are continuously provided.

In the present disclosure, the expression "continuously provided" means that another layer is not present between the layers (that is, an interface is not present).

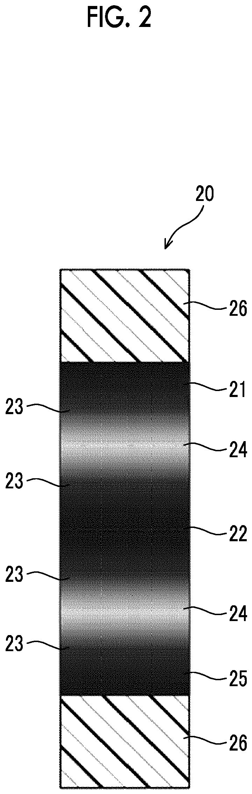

As shown in Fig. 2, a laminate 20 according to the first embodiment may include a mixed layer 23, an inorganic layer 24, a mixed layer 23, and a third resin layer 25 on a surface of a second resin layer 22. In addition, a surface of the third resin layer may be repeatedly provided with a structure consisting of a mixed layer, an inorganic layer, a mixed layer, and an n-th resin layer (not shown).

In Fig. 2, the first resin layer is denoted by reference numeral 21, and the support is denoted by reference numeral 26.

### (First resin layer and second resin layer)

The first resin layer and the second resin layer (hereinafter, collectively referred to as a resin layer) can contain a resin such as an epoxy resin, a (meth)acrylic resin, a liquid crystal polymer, a polyester resin, a polystyrene resin, a fluororesin, a polyimide resin, a polyamide resin, a polyamidoimide resin, a polyetherimide resin, a cellulose resin, a polyurethane resin, a polyether ketone resin, or a polycarbonate resin.

In addition, the resin layer may also contain reactants of a (meth)acrylic monomer and a photopolymerization initiator.

The resin layer may have a monolayer structure or may have a multilayer structure. In a case where the resin layer has a multilayer structure, the configurations of the layers may be the same as or different from each other.

A compound represented by the following general formula can be used as the (meth)acrylic monomer.

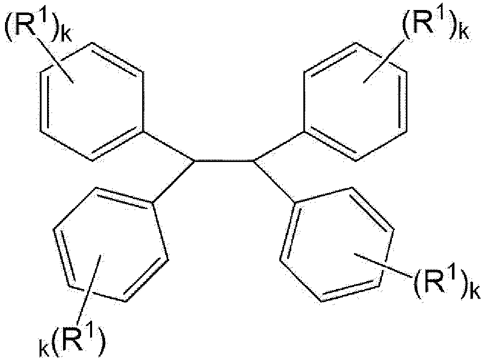

In the general formula, R^{1,}s each independently represent a substituent, which may be the same as or different from each other. k's each independently represent an integer of 0 to 5, which may be the same as or different from each other. In this regard, at least one of R^{1,}s contains a polymerizable group.

Examples of the substituent represented by R¹ include groups consisting of a combination of one or more of -CR²₂- (where R² represents a hydrogen atom or a substituent), -CO-, -O-, a phenylene group, -S-, -C≡C-, -NR³- (where R³ represents a hydrogen atom or a substituent), and -CR⁴=CR⁵- (where R⁴ and R⁵ each represent a hydrogen atom or a substituent), and a polymerizable group, among which a group consisting of a combination of one or more of -CR²₂-, -CO-, -O-, and a phenylene group, and a polymerizable group is preferable.

R² is preferably a hydrogen atom or a hydroxy group.

From the viewpoint of curing properties, it is preferable that at least one R¹ contains a hydroxy group.

The molecular weight of at least one R¹ is preferably 10 to 250 and more preferably 70 to 150.

The bonding position of R¹ is preferably a para position.

k represents an integer of 0 to 5, and is preferably an integer of 0 to 2, more preferably 0 or 1, and still more preferably 1.

In the compound represented by the above general formula, it is preferable that at least two of R¹'s have the same structure.

In addition, it is more preferable that all n's are 1 and two of the four R¹'s have the same structure, and it is still more preferable that all n's are 1 and the four R¹'s have the same structure.

The polymerizable group is preferably a (meth)acryloyl group or an epoxy group, and more preferably a (meth)acryloyl group.

The number of polymerizable groups is preferably 2 or more and more preferably 3 or more.

In addition, the upper limit of the number of polymerizable groups is not particularly limited, and is preferably 8 or less and more preferably 6 or less.

The molecular weight of the compound represented by the above general formula is preferably 600 to 1400 and more preferably 800 to 1200.

Specific examples of the compound represented by the above general formula are shown below, but the present disclosure is not limited thereto.

n in the following compounds represents an integer of 0 to 5, and is preferably an integer of 0 to 2, more preferably 0 or 1, and still more preferably 1.

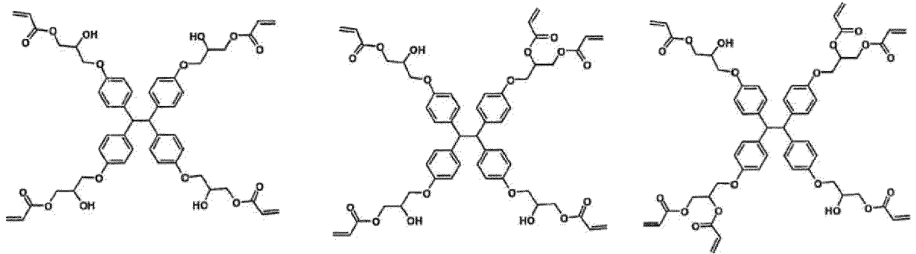

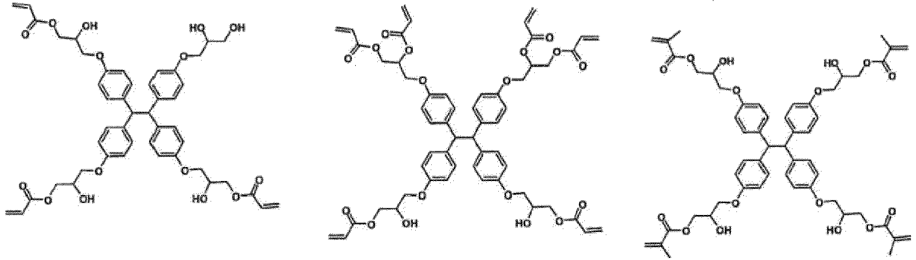

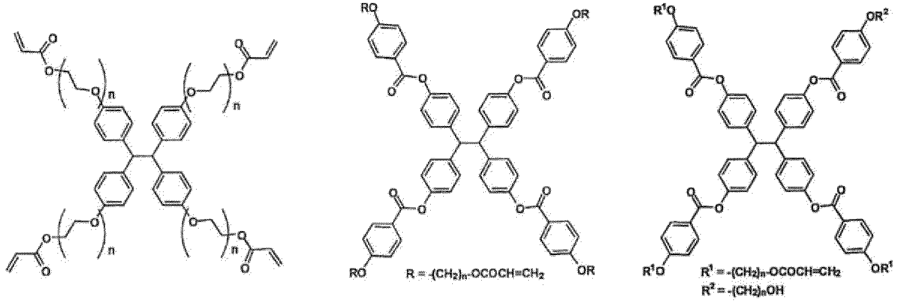

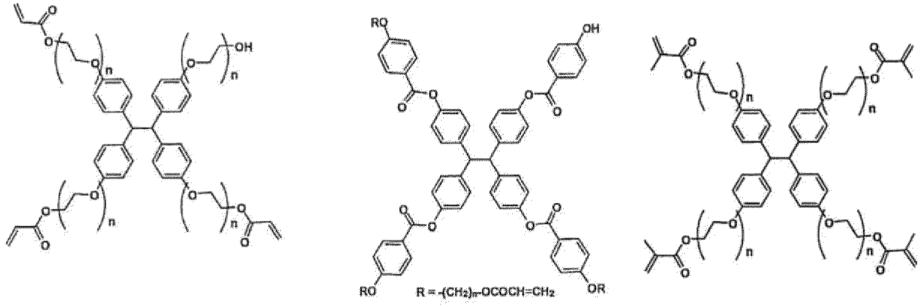

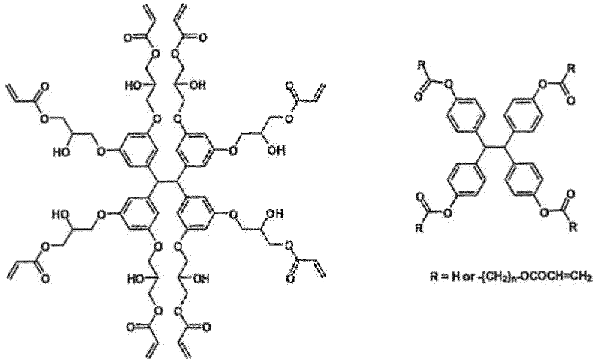

A known photopolymerization initiator in the related art can be used as the photopolymerization initiator, and examples thereof include an α-carbonyl compound, an acyloin ether compound, an α-hydrocarbon-substituted aromatic acyloin compound, a polynuclear quinone compound, a combination of a triarylimidazole dimer and a p-aminophenyl ketone, an acridine compound, a phenazine compound, an oxadiazole compound, and an acylphosphine oxide compound.

The content percentage of the resin with respect to the total mass of the resin layer is not particularly limited, and may be 50% by mass to 100% by mass, 70% by mass to 95% by mass, or 80% by mass to 90% by mass.

The resin layer may contain an additive such as a pigment, a dye, an ultraviolet absorber, a light stabilizer, an antioxidant, or a wax.

From the viewpoint of adhesiveness between layers, the thickness of the resin layer is preferably 0.05 µm to 50 µm, more preferably 0.1 µm to 20 µm, and still more preferably 0.5 µm to 10 µm.

The materials such as resins contained in the first resin layer and the second resin layer may be the same as or different from each other.

In addition, the thicknesses of the first resin layer and the second resin layer may be the same as or different from each other.

In a case where the laminate according to the first embodiment further includes resin layers (a third resin layer, a fourth resin layer, and the like) in addition to the first resin layer and the second resin layer, the materials and the thicknesses of these resin layers may be the same as or different from those of the first resin layer and the second resin layer.

The resin layer can be formed by applying a resin composition containing the above-described resin and the like onto a surface of a support and drying the applied resin composition. In addition, the applied resin composition may be irradiated with ultraviolet rays, electron beams, or the like to be photocured after drying.

### (Inorganic layer)

The inorganic layer can contain an inorganic material, and examples of the inorganic material include an inorganic oxide, an inorganic nitride, a metal oxide, and a metal nitride.

Examples of the inorganic oxide include a silicon oxide and a boron oxide.

Examples of the inorganic nitride include a silicon nitride and a boron nitride.

Examples of the metal oxide include an aluminum oxide, a titanium oxide, an iron oxide, a copper oxide, a chromium oxide, a magnesium oxide, and a zirconium oxide.

Examples of the metal nitride include an aluminum nitride, a titanium nitride, an iron nitride, a copper nitride, a chromium nitride, a magnesium nitride, and a zirconium nitride.

Among the above, from the viewpoint of adhesiveness between layers, the inorganic layer preferably contains one or more inorganic materials selected from the group consisting of a silicon oxide, a silicon nitride, an aluminum oxide, and an aluminum nitride, and more preferably contains one or more inorganic materials selected from the group consisting of a silicon oxide and a silicon nitride.

From the viewpoint of adhesiveness between layers, the inorganic layer preferably contains a silicon oxide, and more preferably contains silicon dioxide.

From the viewpoint of adhesiveness between layers, the content percentage of the inorganic material with respect to the total mass of the inorganic layer is preferably 50% by mass to 100% by mass, more preferably 70% by mass to 95% by mass, and still more preferably 80% by mass to 90% by mass.

The inorganic layer is preferably a continuous layer. In the present disclosure, the continuous layer means a layer in which the void ratio in the inorganic layer is 50% or less. In the present disclosure, the void does not include a defect.

From the viewpoint of adhesiveness between layers, the void ratio of the inorganic layer is preferably 25% or less and more preferably 10% or less. The lower limit of the void ratio of the inorganic layer is not particularly limited, and may be 0%.

In the present disclosure, the void ratio is measured as follows.

First, a cross-sectional image obtained by a method of confirming the presence of a mixed layer which will be described later is prepared.

An area S0 of a portion having a density of 0 to 50 in an inorganic layer forming portion of the cross-sectional image, in which the length in a thickness direction is 2 nm or more, is obtained, the area S0 is divided by an area S1 of the entire inorganic layer forming portion, and the result is multiplied by 100 to obtain a void ratio of the inorganic layer.

Even in a portion where the density is 0 to 50, in a case where the length in a thickness direction is less than 2 nm, the portion is not regarded as a void.

In a case where the laminate according to the first embodiment includes a plurality of inorganic layers, the materials and the thicknesses of the inorganic layers may be the same as or different from each other.

From the viewpoint of adhesiveness between layers, the thickness of the inorganic layer is preferably 30 nm or less, more preferably 28 nm or less, still more preferably 23 nm or less, and particularly preferably 5 nm or less. In addition, in a case where the thickness of the inorganic layer is 30 nm or less, it is possible to suppress a decrease in adhesiveness between layers in a case where the laminate is bent or a force is applied to the laminate.

From the viewpoint of adhesiveness between layers, the thickness of the inorganic layer is preferably 1 nm or more and more preferably 2 nm or more.

The thickness of the inorganic layer is preferably 1 nm to 30 nm, more preferably 1 nm to 28 nm, still more preferably 1 nm to 23 nm, and particularly preferably 2 nm to 5 nm.

The thickness of the inorganic layer can be adjusted by changing a feeding speed of the resin layer, a flow velocity of raw materials, an oxygen gas, or the like used for forming the inorganic layer and the mixed layer, a peak voltage, and the like in a manufacturing method of a laminate which will be described later.

### (Mixed layer)

The laminate according to the first embodiment includes a mixed layer between the first resin layer and the inorganic layer and between the second resin layer and the inorganic layer. The mixed layer is a layer formed in a case where an inorganic layer is formed on the surface of the first resin layer or the second resin layer, and the presence of the mixed layer is confirmed by the following method.

The laminate according to the first embodiment is cut into a size of 3 mm in length × 3 mm in width to obtain a test piece A.

The test piece A is placed in a transmission electron microscope and is irradiated with electron beams for 10 minutes under conditions of a voltage of 300 kV with respect to a cross section of the test piece in a thickness direction.

A cross-sectional image (magnification: 1,000,000 times) of the test piece A after electron beam irradiation is acquired. The density of the cross-sectional image is measured by image analysis software.

In a case where a density of a highest density portion (inorganic layer portion) in the cross-sectional image is set to 100 and a density of a lowest density portion (first resin layer portion and second resin layer portion) in the cross-sectional image is set to 0, it is checked whether or not a portion with a density of 10 to 90 is present between the inorganic layer and the resin layer (in a thickness direction), and in a case where the presence of the portion with a density of 10 to 90 is confirmed, it is determined that the mixed layer is present.

In one embodiment, it may be configured in such a manner that the test piece A is embedded in a molten resin, the resin is irradiated with light and cured to obtain a cured product A, the cured product A is cut out to have a thickness of 20 nm in length to obtain a test piece B, and the test piece B is irradiated with electron beams with respect to a cross section of the test piece B in a thickness direction.

JEM-2011 manufactured by JEOL Ltd. or a device having the same level as JEM-2011 can be used as the transmission electron microscope.

In addition, the density in the cross-sectional image is confirmed by image analysis software Image J or software having the same level as Image J.

In addition, trimethylolpropane triacrylate can be used as the resin.

The mixed layer preferably contains a resin contained in the resin layer and an inorganic material contained in the inorganic layer.

From the viewpoint of adhesiveness between layers, the content percentage of the resin with respect to the total mass of the mixed layer is preferably 5% by mass to 90% by mass, more preferably 20% by mass to 80% by mass, and still more preferably 30% by mass to 70% by mass.

From the viewpoint of adhesiveness between layers, the content percentage of the inorganic material with respect to the total mass of the mixed layer is preferably 10% by mass to 95% by mass, more preferably 20% by mass to 80% by mass, and still more preferably 30% by mass to 70% by mass.

From the viewpoint of adhesiveness between layers and the viewpoint of suppressing a decrease in adhesiveness between layers in a case where the laminate is bent or a force is applied to the laminate, the thickness of the mixed layer is preferably 1 nm to 30 nm, more preferably 2 nm to 25 nm, still more preferably 2 nm to 20 nm, and particularly preferably 3 nm to 15 nm.

The thickness of the mixed layer can be adjusted by changing a feeding speed of the resin layer, a flow velocity of raw materials, an oxygen gas, or the like used for forming the inorganic layer and the mixed layer, a peak voltage, and the like in a manufacturing method of a laminate which will be described later.

### <Support>

The support can contain a resin such as a polyester resin, a polyolefin resin, a polystyrene resin, a polyamide resin, a polycarbonate resin, a polyimide resin, a polyamidoimide resin, or a (meth)acrylic resin.

In addition, the support can contain the above-described additive.

The support may have a monolayer structure or may have a multilayer structure. In a case where the support has a multilayer structure, the configurations of the layers may be the same as or different from each other.

A thickness of the support is not particularly limited, and can be, for example, 10 µm to 500 µm.

A support manufactured by a method known in the related art may be used or a commercially available support may be used as the support.

The laminate according to the first embodiment can be manufactured by a manufacturing method of the laminate according to the first embodiment which will be described later.

### <Laminate according to second embodiment>

A laminate according to a second embodiment is a laminate including a first resin layer and a second resin layer, in which a contrast layer containing an inorganic material is provided between the first resin layer and the second resin layer, and in a case where a cross section of the laminate is irradiated with electron beams for 10 minutes under conditions of a voltage of 300 kV using a transmission electron microscope and a cross-sectional image of the test piece after electron beam irradiation is obtained, a density measured by image analysis software decreases from an inside of the contrast layer of the cross-sectional image toward a surface direction.

In the present disclosure, a range of 2 nm from the surface of the contrast layer in a thickness direction is defined as the "surface" of the contrast layer.

In addition, in the present disclosure, the inside of the contrast layer refers to a portion of the contrast layer other than the surface of the contrast layer.

The laminate according to the second embodiment may include a support on the outermost surface thereof.

The laminate according to the second embodiment may further include a contrast layer and a third resin layer on the surface of the second resin layer. In addition, a surface of the third resin layer may be repeatedly provided with a structure consisting of a contrast layer and an n-th resin layer.

The resin layer and the support are the same as those in the laminate according to the first embodiment, and thus the description thereof will not be repeated here.

### (Contrast layer)

The laminate according to the second embodiment includes a contrast layer between the resin layers.

In the present disclosure, the contrast layer refers to a layer in which a density measured by image analysis software decreases from an inside of the contrast layer toward a surface direction in a cross-sectional image obtained by a transmission electron microscope.

The presence of the contrast layer is confirmed as follows.

The laminate according to the second embodiment is cut into a size of 3 mm in length × 3 mm in width to obtain a test piece a.

The test piece a is placed in a transmission electron microscope and is irradiated with electron beams for 10 minutes under conditions of a voltage of 300 kV with respect to a cross section of the test piece in a thickness direction.

A cross-sectional image (magnification: 1,000,000 times) of the test piece a after electron beam irradiation is acquired.

The density data of the contrast layer is acquired from the cross-sectional image, and it is checked whether or not the density decreases from the inside of the contrast layer toward the surface.

In one embodiment, it may be configured in such a manner that the test piece a is embedded in a molten resin, the resin is irradiated with light and cured to obtain a cured product a, the cured product a is cut out to have a thickness of 20 nm in length to obtain a test piece b, and the test piece b is irradiated with electron beams with respect to a cross section of the test piece b in a thickness direction.

JEM-2011 manufactured by JEOL Ltd. or a device having the same level as JEM-2011 can be used as the transmission electron microscope.

In addition, the density in the cross-sectional image is confirmed by image analysis software Image J or software having the same level as Image J.

In addition, trimethylolpropane triacrylate can be used as the resin.

In a case where a maximum density inside the contrast layer measured by image analysis software is set to 100, and densities of the first resin layer and the second resin layer are set to 0, the contrast layer preferably has a density decrease of 3 to 50 per nm and more preferably a density decrease of 10 to 35 per nm, from the inside toward the surface.

The contrast layer is a layer formed in a case where an inorganic layer is formed on the surface of the first resin layer or the second resin layer, and may include the above-mentioned inorganic layer and mixed layer or may include only the above-mentioned mixed layer. Since the inorganic layer and the mixed layer have been described above, the description thereof will not be repeated here.

From the viewpoint of adhesiveness between layers, the thickness of the contrast layer is preferably 1 nm to 30 nm, more preferably 2 nm to 20 nm, still more preferably 2 nm to 15 nm, and particularly preferably 2 nm to 10 nm.

The laminate according to the second embodiment can be manufactured by a manufacturing method of a laminate which will be described later.

The laminate according to the first embodiment and the laminate according to the second embodiment can be applied to applications for an electronic device such as an organic electroluminescence (EL) display, organic EL lighting, an organic solar cell, or a copper indium gallium selenide (CIGS) solar cell, an optical device such as AR glasses, and the like.

### <Manufacturing method of laminate according to first embodiment>

A manufacturing method of the laminate according to the first embodiment includes a step of forming a mixed layer and an inorganic layer in this order on each surface of a first resin layer and a second resin layer by plasma chemical vapor deposition to obtain a first laminate including the first resin layer, the mixed layer, and the inorganic layer and a second laminate including the second resin layer, the mixed layer, and the inorganic layer (hereinafter, also referred to as a step of forming a mixed layer and an inorganic layer); and a step of laminating the inorganic layer of the first laminate and the inorganic layer of the second laminate (hereinafter, also referred to as a laminating step).

According to the manufacturing method of the laminate according to the first embodiment, it is possible to manufacture a laminate having excellent adhesiveness between layers. Although the reason why the above-described effect is exhibited is not clear, it is presumed as follows.

In the manufacturing method of the laminate according to the first embodiment, a mixed layer is formed by forming an inorganic layer on the first resin layer and the second resin layer by plasma chemical vapor deposition. It is presumed that this is because the surfaces of the first resin layer and the second resin layer are etched by plasma chemical vapor deposition, and an inorganic material for forming an inorganic layer penetrates into the etched portion, resulting in the formation of a mixed layer.

Furthermore, it is presumed that the mixed layer has excellent adhesiveness to the first resin layer and the inorganic layer and excellent adhesiveness to the second resin layer and the inorganic layer, the inorganic layer formed by plasma chemical vapor deposition is surface activated, and the adhesiveness between the inorganic layers is also excellent by laminating the inorganic layers, and thus the adhesiveness between layers of the laminate manufactured by the manufacturing method of the laminate according to the first embodiment is excellent.

In the manufacturing method of the laminate according to the first embodiment, the step of forming a mixed layer and an inorganic layer, and the laminating step may be repeated a plurality of times.

For example, the manufacturing method of the laminate according to the first embodiment can include a step of forming a mixed layer and an inorganic layer in this order on each surface of the second resin layer of the manufactured laminate and a separately prepared third resin layer by plasma chemical vapor deposition to obtain a third laminate including the first resin layer, the mixed layer, the inorganic layer, the mixed layer, the second resin layer, the mixed layer, and the inorganic layer, and a fourth laminate including the third resin layer, the mixed layer, and the inorganic layer; and a step of laminating the inorganic layer of the third laminate provided on the outermost surface and the inorganic layer of the fourth laminate.

### (Step of forming mixed layer and inorganic layer)

The manufacturing method of the laminate according to the first embodiment includes a step of forming a mixed layer and an inorganic layer in this order on each surface of a first resin layer and a second resin layer by plasma chemical vapor deposition (hereinafter, also referred to as plasma CVD) to obtain a first laminate including the first resin layer, the mixed layer, and the inorganic layer and a second laminate including the second resin layer, the mixed layer, and the inorganic layer.

Since the details of the first resin layer, the second resin layer, the mixed layer, and the inorganic layer have been described above, the description thereof will not be repeated here.

The formation of the mixed layer and the inorganic layer on the resin layer is carried out by plasma chemical vapor deposition. More specifically, the mixed layer and the inorganic layer can be formed by a method in which oxygen gas containing a raw material for forming an inorganic layer and a mixed layer such as silane is brought into a plasma state by plasma excitation power and the surface of the resin layer is subjected to a plasma treatment using the oxygen gas in the plasma state.

Examples of the plasma treatment method include a method in which the surface of the resin layer is irradiated with plasma using a plasma irradiation device, and a method in which the resin layer is passed between an electrode roller and a support roller in the oxygen gas atmosphere.

In addition to the oxygen gas containing a raw material, hydrogen gas, gas containing nitrogen atoms, inert gas, or the like may be used.

Examples of the gas containing nitrogen atoms include nitrogen gas (N₂), ammonia gas (NH₃), and nitrous oxide gas (N₂O).

Examples of the inert gas include helium gas, neon gas, argon gas, krypton gas, xenon gas, and radon gas.

From the viewpoint of forming a mixed layer and an inorganic layer on the surface of the resin layer and improving the adhesiveness between layers, the flow velocity of the oxygen gas is preferably 30 mL/min to 350 mL/min, more preferably 40 mL/min to 300 mL/min, and still more preferably 50 mL/min to 250 mL/min.

From the viewpoint of forming a mixed layer and an inorganic layer on the surface of the resin layer and improving the adhesiveness between layers, the flow velocity of the raw material is preferably 2 mg/min to 17 mg/min, more preferably 3 mg/min to 15 mg/min, and still more preferably 4 mg/min to 10 mg/min.

The peak voltage of the plasma excitation power used for plasma conversion of the raw material gas for forming a mixed layer and an inorganic layer on the surface of the resin layer and improving the adhesiveness between layers is preferably 3 kV to 17 kV, more preferably 4 kV to 15 kV, and still more preferably 6 kV to 10 kV from the viewpoint of adhesiveness between layers.

In the present disclosure, the "peak voltage of the plasma excitation power" means a maximum value of the plasma excitation power in the plasma conversion of the raw material gas.

### (Laminating step)

The method of laminating the first laminate and the second laminate is not particularly limited, and the first laminate and the second laminate may be laminated by facing the inorganic layer of the first laminate and the inorganic layer of the second laminate to each other and pressure bonding the inorganic layers together.

The pressure bonding of the laminates may be carried out by superimposing the laminates and passing the superimposed laminates between rollers.

The pressure applied to the laminate by the roller is not particularly limited, and can be, for example, 0.1 MPa to 5 MPa.

In the manufacturing method of the laminate according to the first embodiment, it is preferable that the formation of the mixed layer and the inorganic layer on each of the first resin layer and the second resin layer and the lamination of the first laminate and the second laminate are carried out at the same time. As a result, unevenness is formed on the surface of the resin layer by etching, and the penetration of a material for forming an inorganic layer into the uneven portion and the lamination of the inorganic layers of the laminates are carried out at the same time, so the smoothness of the interface between the laminated inorganic layers tends to improve, and the adhesiveness between layers tends to improve.

From the viewpoint of adhesiveness between layers, the surface roughness Ra of the inorganic layer of the first laminate and the surface roughness Ra of the inorganic layer of the second laminate are each preferably 2 nm or less and more preferably 1.5 nm or less. The lower limit of the surface roughness is not particularly limited, and can be, for example, 0.3 nm or more.

In the present disclosure, the surface roughness Ra is measured based on "JIS B 0601 (2013)".

The measurement is carried out using an AFM (SPA400, manufactured by Hitachi High-Tech Corporation) or a device having the same level as the AFM, as a measurement device.

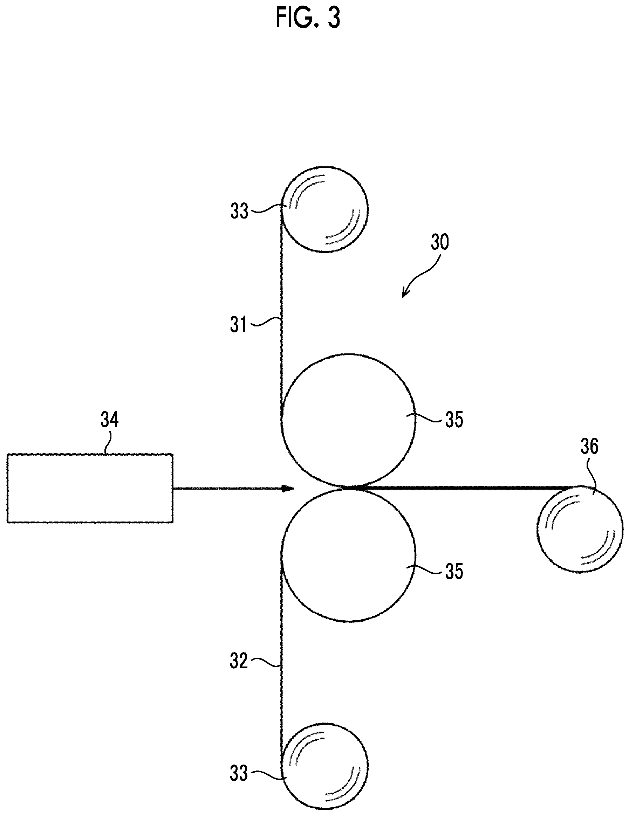

Hereinafter, one embodiment of the manufacturing method of the laminate according to the first embodiment will be described with reference to Fig. 3 to Fig. 5.

Fig. 3 shows one embodiment of a device that can be used in the manufacturing method of the laminate according to the first embodiment.

A device 30 shown in Fig. 3 includes an unwinding roller 33 for feeding a first resin layer 31 and a second resin layer 32.

The first resin layer 31 and the second resin layer 32 may each be formed on a surface of a support, and a laminate including the support and the resin layer may be unwound.

In addition, the device 30 includes a plasma irradiation device 34 that applies plasma to form a mixed layer and an inorganic layer on the surfaces of the first resin layer 31 and the second resin layer 32 to form a first laminate and a second laminate.

**In** addition, the device 30 includes a pressure roller 35 for laminating the inorganic layer of the first laminate and the inorganic layer of the second laminate.

In addition, the device 30 includes a roller 36 (winding roller) that winds up a laminate obtained by laminating the first laminate and the second laminate by the pressure roller.

With the device 30, the formation of the mixed layer and the inorganic layer on each of the first resin layer and the second resin layer and the lamination of the first laminate and the second laminate can be carried out at the same time.

First, the first resin layer 31 and the second resin layer 32 are fed out from the unwinding roller 33.

Next, plasma is applied toward a bonding portion of the pressure roller 35 by the plasma irradiation device 34 to form a mixed layer and an inorganic layer on the surfaces of the first resin layer 31 and the second resin layer 32 to obtain a first laminate and a second laminate, and the inorganic layer of the first laminate and the inorganic layer of the second laminate are laminated.

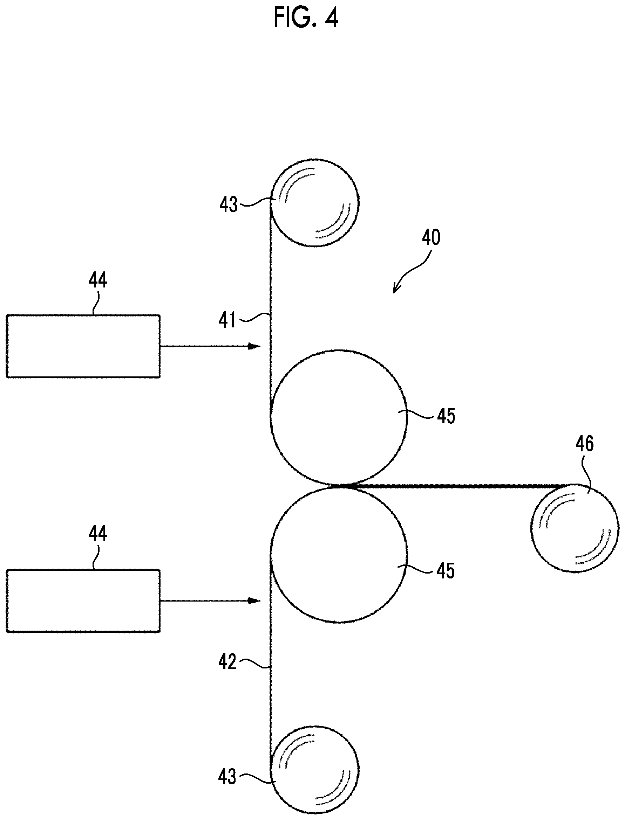

Fig. 4 shows another embodiment of the device that can be used in the manufacturing method of the laminate according to the first embodiment.

In a device 40 shown in Fig. 4, after the formation of the mixed layer and the inorganic layer on each of the first resin layer and the second resin layer, the lamination of the first laminate and the second laminate is carried out.

In the device 40, the first resin layer is denoted by reference numeral 41, the second resin layer is denoted by reference numeral 42, the unwinding roller is denoted by reference numeral 43, the plasma irradiation device is denoted by reference numeral 44, the pressure roller is denoted by reference numeral 45, and the winding roller is denoted by reference numeral 47.

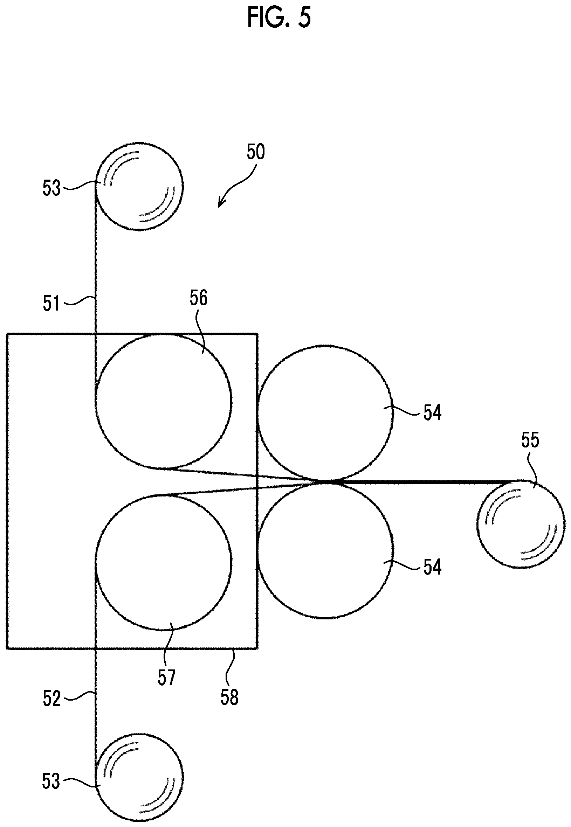

Fig. 5 shows yet another embodiment of the device that can be used in the manufacturing method of the laminate according to the first embodiment.

A device 50 shown in Fig. 5 includes an electrode roller 56 and a support roller 57, and can convert oxygen gas containing a raw material into plasma between these rollers 56 and 57 to form a mixed layer and an inorganic layer on the surfaces of the first resin layer and the second resin layer.

In addition, the device 50 shown in Fig. 5 may include a casing 58 for filling the oxygen gas and a nozzle (not shown) for introducing the oxygen gas, between the electrode roller 56 and the support roller 57.

In Fig. 5, the first resin layer is denoted by reference numeral 51, the second resin layer is denoted by reference numeral 52, the unwinding roller is denoted by reference numeral 53, the pressure roller is denoted by reference numeral 54, and the winding roller is denoted by reference numeral 55.

### <Manufacturing method of laminate according to second embodiment>

A manufacturing method of the laminate according to the second embodiment includes a step of forming a contrast layer on each surface of a first resin layer and a second resin layer by plasma chemical vapor deposition to obtain a first laminate including the first resin layer and the contrast layer and a second laminate including the second resin layer and the contrast layer (hereinafter, also referred to as a step of forming a contrast layer); and a step of laminating the contrast layer of the first laminate and the contrast layer of the second laminate (hereinafter, also referred to as a laminating step).

In the manufacturing method of the laminate according to the second embodiment, the step of forming a contrast layer and the laminating step may be repeated a plurality of times.

For example, the manufacturing method of the laminate according to the second embodiment can include a step of forming a contrast layer on each surface of the second resin layer of the manufactured laminate and a separately prepared third resin layer by plasma chemical vapor deposition to obtain a third laminate including the first resin layer, the contrast layer, the second resin layer, and the contrast layer, and a fourth laminate including the third resin layer and the contrast layer; and a step of laminating the contrast layer of the third laminate provided on the outermost surface and the contrast layer of the fourth laminate.

### (Step of forming contrast layer)

The manufacturing method of the laminate according to the second embodiment includes a step of forming a contrast layer on each surface of a first resin layer and a second resin layer by plasma chemical vapor deposition to obtain a first laminate including the first resin layer and the contrast layer and a second laminate including the second resin layer and the contrast layer.

Since the details of the first resin layer, the second resin layer, and the contrast layer have been described above, the description thereof will not be repeated here.

The formation of the contrast layer on the resin layer is carried out by plasma chemical vapor deposition. More specifically, the contrast layer can be formed by a method in which gas obtained by mixing raw material gas such as silane and oxygen gas is brought into a plasma state by excitation power and the surface of the resin layer is subjected to a plasma treatment using the gas in the plasma state.

The contrast layer is formed in a case where the etching rate of the surface of the resin layer is higher than the formation rate of the inorganic layer on the surface of the resin layer. The formation rate of the inorganic layer can be adjusted by changing the flow velocities of the oxygen gas and the raw material. The etching rate can be adjusted by changing the peak voltage.

Examples of the plasma treatment method include a method in which the surface of the resin layer is irradiated with plasma using a plasma irradiation device, and a method in which the resin layer is passed between an electrode roller and a support roller in the oxygen gas atmosphere.

In addition to the raw material gas and the oxygen gas, hydrogen gas, gas containing nitrogen atoms, inert gas, or the like may be used.

Examples of the gas containing nitrogen atoms include nitrogen gas (N₂), ammonia gas (NH₃), and nitrous oxide gas (N₂O).

Examples of the inert gas include helium gas, neon gas, argon gas, krypton gas, xenon gas, and radon gas.

From the viewpoint of forming a contrast layer on the surface of the resin layer and improving the adhesiveness between layers, the flow velocity of the oxygen gas is preferably 30 mL/min to 350 mL/min, more preferably 40 mL/min to 300 mL/min, and still more preferably 50 mL/min to 250 mL/min.

From the viewpoint of forming a contrast layer including no inorganic layer on the surface of the resin layer and improving the adhesiveness between layers, the flow velocity of the oxygen gas is preferably 5 mL/min to 28 mL/min, more preferably 6 mL/min to 25 mL/min, and still more preferably 7 mL/min to 23 mL/min.

From the viewpoint of forming a contrast layer on the surface of the resin layer and improving the adhesiveness between layers, the flow velocity of the raw material is preferably 2 mg/min to 17 mg/min, more preferably 3 mg/min to 15 mg/min, and still more preferably 4 mg/min to 10 mg/min.

From the viewpoint of forming a contrast layer including no inorganic layer on the surface of the resin layer and improving the adhesiveness between layers, the flow velocity of the raw material is preferably 0.1 mg/min to 1.8 mg/min, more preferably 0.3 mg/min to 1.5 mg/min, and still more preferably 0.5 mg/min to 1.3 mg/min.

The peak voltage of the plasma excitation power used for plasma conversion of the raw material gas for forming a contrast layer on the surface of the resin layer and improving the adhesiveness between layers is preferably 3 kV to 17 kV, more preferably 4 kV to 15 kV, and still more preferably 6 kV to 10 kV from the viewpoint of adhesiveness between layers.

### (Laminating step)

The method of laminating the first laminate and the second laminate is not particularly limited, and the first laminate and the second laminate may be laminated by facing the contrast layer of the first laminate and the contrast layer of the second laminate to each other and pressure bonding the contrast layers together.

The pressure bonding of the laminates may be carried out by superimposing the laminates and passing the superimposed laminates between rollers.

The pressure applied to the laminate by the roller is not particularly limited, and can be, for example, 0.1 MPa to 5 MPa.

In the manufacturing method of the laminate according to the second embodiment, it is preferable that the formation of the contrast layer on each of the first resin layer and the second resin layer and the lamination of the first laminate and the second laminate are carried out at the same time. As a result, unevenness is formed on the surface of the resin layer by etching, and the penetration of a material for forming a contrast layer into the uneven portion and the lamination of the contrast layers of the laminates are carried out at the same time, so the smoothness of the interface between the laminated contrast layers tends to improve, and the adhesiveness between layers tends to improve.

From the viewpoint of adhesiveness between layers, the surface roughness of the contrast layer of the first laminate and the surface roughness of the contrast layer of the second laminate are each preferably 2 nm or less and more preferably 1.5 nm or less.

The manufacturing method of the laminate according to the second embodiment can also use the device that can be used in the manufacturing method of the laminate according to the first embodiment.

### Examples

Hereinafter, the present disclosure will be described in detail with reference to Examples. However, the present disclosure is not limited to the following Examples.

### <Example 1>

Two polyethylene terephthalate films (A4100, manufactured by Toyobo Co., Ltd.) each having a thickness of 100 µm and a width of 50 mm were prepared as supports.

A resin composition having the following composition was applied onto one surface of each support, dried, and photocured to form a first resin layer and a second resin layer each having a thickness of 2 µm.

### (Composition of resin composition)

· Acrylic monomer (TMPTA, manufactured by Shin-Nakamura Chemical Co., Ltd.) 95.5% by mass
· Photopolymerization initiator (KTO46, manufactured by Lamberti S.p.A.) 4.5% by mass

The device 30 shown in Fig. 3 was prepared.

A laminate including the support and the first resin layer and a laminate including the support and the second resin layer were transported from each of the unwinding rollers 33 at a speed of 1 m/min.

Plasma was applied from the following plasma irradiation device 34 under the following conditions toward the bonding portion of the pressure roller 35 provided in the device 30 to form a mixed layer and an inorganic layer (5 nm) on the surfaces of the first resin layer and the second resin layer to obtain a first laminate and a second laminate, and the inorganic layer (silicon dioxide) of the first laminate and the inorganic layer (silicon dioxide) of the second laminate were laminated to obtain a laminate. The pressure applied to the laminate by the pressure roller was 0.2 MPa. The thickness of the inorganic layer in the laminate was 10 nm.

In order to measure the surface roughness Ra of each of the inorganic layer of the first laminate and the inorganic layer of the second laminate, the first laminate and the second laminate were produced under the same conditions as those described above, and the surface roughness Ra of the inorganic layer included in each laminate was measured using an AFM (SPA400, manufactured by Hitachi High-Tech Corporation) based on "JIS B 0601 (2013)". As a result, the surface roughness Ra of the inorganic layer of each laminate was 0.9 nm.

### (Plasma irradiation device)

· Atmospheric pressure plasma jet device (burette nozzle double pipe type)
· Double pipe structure: outer diameter of outer pipe: Φ15 mm, outer diameter of inner pipe: Φ8 mm
· A copper electrode is disposed outside outer pipe
· Peak voltage: 8 kV
· Pulse width: 5 microseconds
· Bipolar pulse: 10 kHz
· Gas flowing through outer pipe: helium gas (plasma generation gas, flow velocity: 10 L/min)
· Gas flowing through inner pipe: tetraethoxysilane (also referred to as TEOS, flow velocity: 5 mg/min), oxygen gas (flow velocity: 100 mL/min), and nitrogen gas (flow velocity: 500 mL/min)

The laminate manufactured as described above was cut into a size of 3 mm in length × 3 mm in width to obtain a test piece A.

The test piece A was embedded in molten trimethylolpropane triacrylate and then irradiated with light to obtain a cured product A (thickness: 200 µm, length: 5 mm, width: 10 mm), the cured product A was cut out to have a thickness of 20 nm in length to obtain a test piece B, and the test piece B was irradiated with electron beams for 10 minutes under conditions of a voltage of 300 kV with respect to a cross section of the test piece B in a thickness direction.

A cross-sectional image (magnification: 1,000,000 times) of the test piece B after electron beam irradiation was acquired. The density of the cross-sectional image was measured by image analysis software.

In a case where a density of a highest density portion (inorganic layer portion) in the cross-sectional image was set to 100 and a density of a lowest density portion (first resin layer portion and second resin layer portion) in the cross-sectional image was set to 0, the presence of a portion with a density of 10 to 90 could be confirmed between the inorganic layer and the first resin layer and between the inorganic layer and the second resin layer.

JEM-2011 manufactured by JEOL Ltd. was used as a transmission electron microscope.

In addition, the density in the cross-sectional image was confirmed by image analysis software Image J.

The thicknesses of the inorganic layer and the mixed layer included in the laminate were measured from the cross-sectional image and were found to be 10 nm and 5 nm, respectively.

An area S0 of a portion having a density of 0 to 50 in an inorganic layer forming portion of the cross-sectional image, in which the length in a thickness direction was 2 nm or more, was obtained, the area S0 was divided by an area S1 of the entire inorganic layer forming portion, and the result was multiplied by 100 to obtain a void ratio of the inorganic layer, which was less than 5%.

### <Example 2>

A laminate was manufactured in the same manner as in Example 1, except that the peak voltage was changed to 6 kV

In the same manner as in Example 1, the presence of the mixed layer was confirmed, and the thicknesses of the inorganic layer and the mixed layer included in the laminate were measured and found to be 9 nm and 2 nm, respectively.

In addition, the void ratio of the inorganic layer was obtained in the same manner as in Example 1, and was found to be less than 5%.

In addition, the surface roughness Ra of the inorganic layer was obtained in the same manner as in Example 1 and was found to be 0.9 nm.

### <Example 3>

A laminate was manufactured in the same manner as in Example 1, except that the peak voltage was changed to 10 kV

In the same manner as in Example 1, the presence of the mixed layer was confirmed, and the thicknesses of the inorganic layer and the mixed layer included in the laminate were measured and found to be 12 nm and 10 nm, respectively.

In addition, the void ratio of the inorganic layer was obtained in the same manner as in Example 1, and was found to be less than 5%.

In addition, the surface roughness Ra of the inorganic layer was obtained in the same manner as in Example 1 and was found to be 1.0 nm.

### <Example 4>

A laminate was manufactured in the same manner as in Example 1, except that the peak voltage was changed to 15 kV

In the same manner as in Example 1, the presence of the mixed layer was confirmed, and the thicknesses of the inorganic layer and the mixed layer included in the laminate were measured and found to be 14 nm and 28 nm, respectively.

In addition, the void ratio of the inorganic layer was obtained in the same manner as in Example 1, and was found to be less than 5%.

In addition, the surface roughness Ra of the inorganic layer was obtained in the same manner as in Example 1 and was found to be 1.2 nm.

### <Example 5>

A laminate was manufactured in the same manner as in Example 1, except that the flow velocities of the tetraethoxysilane gas and the oxygen gas were changed to 10 mg/min and 200 mL/min, respectively.

In the same manner as in Example 1, the presence of the mixed layer was confirmed, and the thicknesses of the inorganic layer and the mixed layer included in the laminate were measured and found to be 22 nm and 5 nm, respectively.

In addition, the void ratio of the inorganic layer was obtained in the same manner as in Example 1, and was found to be less than 5%.

In addition, the surface roughness Ra of the inorganic layer was obtained in the same manner as in Example 1 and was found to be 1.3 nm.

### <Example 6>

A laminate was manufactured in the same manner as in Example 1, except that the flow velocities of the tetraethoxysilane gas and the oxygen gas were changed to 15 mg/min and 300 mL/min, respectively.

In the same manner as in Example 1, the presence of the mixed layer was confirmed, and the thicknesses of the inorganic layer and the mixed layer included in the laminate were measured and found to be 28 nm and 5 nm, respectively.

In addition, the void ratio of the inorganic layer was obtained in the same manner as in Example 1, and was found to be less than 5%.

In addition, the surface roughness Ra of the inorganic layer was obtained in the same manner as in Example 1 and was found to be 1.4 nm.

### <Example 7>

A laminate was manufactured in the same manner as in Example 1, except that the flow velocities of the tetraethoxysilane gas and the oxygen gas were changed to 2 g/min and 40 mL/min, respectively.

In the same manner as in Example 1, the presence of the mixed layer was confirmed, and the thicknesses of the inorganic layer and the mixed layer included in the laminate were measured and found to be 4 nm and 5 nm, respectively.

In addition, the void ratio of the inorganic layer was obtained in the same manner as in Example 1, and was found to be less than 5%.

In addition, the surface roughness Ra of the inorganic layer was obtained in the same manner as in Example 1 and was found to be 0.8 nm.

### <Example 8>

A laminate was manufactured in the same manner as in Example 1, except that tetraethoxysilane was changed to trimethylaluminum.

In the same manner as in Example 1, the presence of the mixed layer was confirmed, and the thicknesses of the inorganic layer (aluminum oxide) and the mixed layer included in the laminate were measured and found to be 10 nm and 4 nm, respectively.

In addition, the void ratio of the inorganic layer was obtained in the same manner as in Example 1, and was found to be less than 5%.

In addition, the surface roughness Ra of the inorganic layer was obtained in the same manner as in Example 1 and was found to be 1 nm.

### <Example 9>

The laminate manufacturing device 40 shown in Fig. 4 was prepared.

A laminate including the support and the first resin layer and a laminate including the support and the second resin layer were transported from each of the unwinding rollers 43 at a speed of 1 m/min.

Plasma was applied from the following plasma irradiation device under the following conditions to form a mixed layer and an inorganic layer on the surfaces of the first resin layer and the second resin layer to obtain a first laminate and a second laminate.

The inorganic layer of the first laminate and the inorganic layer of the second laminate were laminated by the pressure roller 45 provided in the device 40 to obtain a laminate. The pressure applied to the laminate by the pressure roller was 0.2 MPa.

### (Plasma irradiation device)

· Atmospheric pressure plasma jet device (burette nozzle double pipe type)
· Double pipe structure: outer diameter of outer pipe: Φ15 mm, outer diameter of inner pipe: Φ8 mm
· A copper electrode is disposed outside outer pipe
· Peak voltage: 8 kV
· Pulse width: 5 microseconds
· Bipolar pulse: 10 kHz
· Gas flowing through outer pipe: helium gas (plasma generation gas, flow velocity: 10 L/min)
· Gas flowing through inner pipe: tetraethoxysilane gas (flow velocity: 2 mg/min), oxygen gas (flow velocity: 40 mL/min), and nitrogen gas (flow velocity: 500 mL/min)

In the same manner as in Example 1, the presence of the mixed layer was confirmed, and the thicknesses of the inorganic layer and the mixed layer included in the laminate were measured and found to be 4 nm and 5 nm, respectively.

In addition, the void ratio of the inorganic layer was obtained in the same manner as in Example 1, and was found to be 25%.

In addition, the surface roughness Ra of the inorganic layer was obtained in the same manner as in Example 1 and was found to be 0.8 nm.

### <Example 10>

A laminate was manufactured in the same manner as in Example 9, except that the area from the plasma irradiation unit to the pressure roller was surrounded by a casing and the inside of the casing was made into a nitrogen atmosphere.

In the same manner as in Example 1, the presence of the mixed layer was confirmed, and the thicknesses of the inorganic layer and the mixed layer included in the laminate were measured and found to be 4 nm and 5 nm, respectively.

In addition, the void ratio of the inorganic layer was obtained in the same manner as in Example 1, and was found to be 10%.

In addition, the surface roughness Ra of the inorganic layer was obtained in the same manner as in Example 1 and was found to be 0.8 nm.

### <Example 11>

The laminate manufacturing device 50 shown in Fig. 5 was prepared.

A laminate including the support and the first resin layer and a laminate including the support and the second resin layer were transported from each of the unwinding rollers 53 at a speed of 1 m/min.

Tetraethoxysilane gas (flow velocity: 5 mg/min), oxygen gas (flow velocity: 100 mL/min), and nitrogen gas (flow velocity: 500 mL/min) were introduced from a nozzle into the casing 58, and the laminate including the support and the first resin layer and the laminate including the support and the second resin layer were allowed to pass between the electrode roller 56 and the support roller 57 provided in the casing 58 to form a mixed layer and an inorganic layer on the surfaces of the first resin layer and the second resin layer to obtain a first laminate and a second laminate.

The inorganic layer of the first laminate and the inorganic layer of the second laminate were laminated by the pressure roller 54 provided in the device 50 to obtain a laminate. The pressure applied to the laminate by the pressure roller was 0.2 MPa.

In the same manner as in Example 1, the presence of the mixed layer was confirmed, and the thicknesses of the inorganic layer and the mixed layer included in the laminate were measured and found to be 3 nm and 6 nm, respectively.

In addition, the void ratio of the inorganic layer was obtained in the same manner as in Example 1, and was found to be 25%.

In addition, the surface roughness Ra of the inorganic layer was obtained in the same manner as in Example 1 and was found to be 0.8 nm.

### <Comparative Example 1>

A laminate was manufactured in the same manner as in Example 1, except that a sputtering device was provided instead of the atmospheric pressure plasma jet device, and an inorganic layer (silicon dioxide) was formed on the surfaces of the first resin layer and the second resin layer by sputtering under the following conditions.

### (Conditions of sputtering)

· Argon flow rate: 100 mL/min
· Power: 200 W
· Frequency: 13.56 MHz

In the same manner as in Example 1, it was checked whether or not the mixed layer was present, but the presence of the mixed layer was not confirmed. In addition, the thickness of the inorganic layer included in the laminate was measured and found to be 10 nm.

In addition, the void ratio of the inorganic layer was obtained in the same manner as in Example 1, and was found to be 27%.

In addition, the surface roughness Ra of the inorganic layer was obtained in the same manner as in Example 1 and was found to be 0.7 nm.

### <Evaluation of adhesiveness - 1>

A laminate was manufactured in the same manner as in the above-described Examples and Comparative Examples, except that, in a case of forming the first resin layer on the surface of the support, a film having a width of 50 mm and a length of 10 mm was interposed at an end part of the support to provide a portion where the support and the first resin layer were not closely attached to each other.

The laminate was cut into a size of 50 mm in a transport direction × 25 mm in a width direction to obtain a test piece, and the support on the second resin layer side was attached and fixed to a base by a double-sided tape.

Next, the non-closely attached portion of the support in contact with the first resin layer provided in the test piece was folded back.

The folded-back portion was pulled in a direction of 180° (peeling rate: 5 mm/sec) using a peeling tester (universal tester AGS-100NX, manufactured by Shimadzu Corporation) to measure a maximum load (N/25 mm). The measurement results are summarized in Table 1.

### <Evaluation of adhesiveness - 2>

The test piece produced in the section of <Evaluation of adhesiveness - 1> was subjected to the following bending test, and then the maximum load (N/25 mm) was measured in the same manner as in the section of <Evaluation of adhesiveness - 1>. The results are summarized in Table 1.

One end of the test piece in a length direction was fixed. A Φ10 mm rod was placed at the center of the test piece, and with the rod being taken as a fulcrum, one end of the test piece that was not fixed was bent by 180° and then returned to its original position. The bending was repeated 10000 times.

**[Table 1]**

| | Method of forming inorganic layer | Peak voltage (kV) | Flow velocity of TEOS (mg/min) | Flow velocity of trimethylaluminum (mg/min) | Flow velocity of oxygen gas (mL/min) | Timing of formation of mixed layer and inorganic layer and lamination of first resin layer and second resin layer | Thickness of inorganic layer (nm) | Thickness of mixed layer (nm) | Void ratio of inorganic layer (%) | Evaluati on of a dhesive ness-1 (N/25 mm) | Evaluati on of a dhesive ness-2 (N/25 mm) |
|---|---|---|---|---|---|---|---|---|---|---|---|
| Example 1 | Plasma CVD | 8 | 5 | - | 100 | At the same time | 10 | 5 | <5 | >20 | >20 |
| Example 2 | Plasma CVD | 6 | 5 | - | 100 | At the same time | 9 | 2 | <5 | >20 | >20 |
| Example 3 | Plasma CVD | 10 | 5 | - | 100 | At the same time | 12 | 10 | <5 | >20 | >20 |
| Example 4 | Plasma CVD | 15 | 5 | - | 100 | At the same time | 14 | 28 | <5 | >20 | >20 |
| Example 5 | Plasma CVD | 8 | 10 | - | 200 | At the same time | 22 | 5 | <5 | >20 | >20 |
| Example 6 | Plasma CVD | 8 | 15 | - | 300 | At the same time | 28 | 5 | <5 | >20 | >20 |
| Example 7 | Plasma CVD | 8 | 2 | - | 40 | At the same time | 4 | 5 | <5 | >20 | >20 |
| Example 8 | Plasma CVD | 8 | - | 5 | 100 | At the same time | 10 | 4 | <5 | >20 | >20 |
| Example 9 | Plasma CVD | 8 | 2 | - | 40 | Not at the same time | 4 | 5 | 25 | 9 | 9 |
| Example 10 | Plasma CVD | 8 | 2 | - | 40 | Not at the same time | 4 | 5 | 10 | 14 | 14 |
| Example 11 | Plasma CVD | 8 | 2 | - | 40 | Not at the same time | 3 | 6 | 25 | 10 | 10 |
| Comparative Example 1 | Sputtering | - | - | - | - | - | 10 | - | 27 | <1 | <1 |

### <Example 12>

Two polyethylene terephthalate films (A4100, manufactured by Toyobo Co., Ltd.) each having a thickness of 100 µm and a width of 50 mm were prepared as supports.

A resin composition having the following composition was applied onto one surface of each support, dried, and photocured to form a first resin layer and a second resin layer each having a thickness of 2 µm.

### (Composition of resin composition)

· Acrylic monomer (TMPTA, manufactured by Shin-Nakamura Chemical Co., Ltd.) 95.5% by mass
· Photopolymerization initiator (KTO46, manufactured by Lamberti S.p.A.) 4.5% by mass

The device 30 shown in Fig. 3 was prepared.

A laminate including the support and the first resin layer and a laminate including the support and the second resin layer were transported from each of the unwinding rollers 33 at a speed of 1 m/min.

Plasma was applied from the following plasma irradiation device 34 under the following conditions toward the bonding portion of the pressure roller 35 provided in the device 30 to form a contrast layer on the surfaces of the first resin layer and the second resin layer to obtain a first laminate and a second laminate, and the contrast layer of the first laminate and the contrast layer of the second laminate were laminated to obtain a laminate. The pressure applied to the laminate by the pressure roller was 0.2 MPa.

### (Plasma irradiation device)

· Atmospheric pressure plasma jet device (burette nozzle double pipe type)
· Double pipe structure: outer diameter of outer pipe: Φ15 mm, outer diameter of inner pipe: Φ8 mm
· A copper electrode is disposed outside outer pipe
· Peak voltage: 8 kV
· Pulse width: 5 microseconds
· Bipolar pulse: 10 kHz
· Gas flowing through outer pipe: helium gas (plasma generation gas, flow velocity: 10 L/min)
· Gas flowing through inner pipe: tetraethoxysilane (also referred to as TEOS, flow velocity: 5 mg/min), oxygen gas (flow velocity: 100 mL/min), and nitrogen gas (flow velocity:
500 mL/min)

The laminate manufactured as described above was cut into a size of 3 mm in length × 3 mm in width to obtain a test piece a.

The test piece a was embedded in molten trimethylolpropane triacrylate and then irradiated with light to obtain a cured product b (thickness: 200 µm, length: 5 mm, width: 10 mm), the cured product b was cut out to have a thickness of 20 nm in length to obtain a test piece b, and the test piece b was irradiated with electron beams for 10 minutes under conditions of a voltage of 300 kV with respect to a cross section of the test piece b in a thickness direction.

A cross-sectional image (magnification: 1,000,000 times) of the test piece b after electron beam irradiation was acquired. The density of the cross-sectional image was measured by image analysis software.

In a case where the maximum density inside the contrast layer of the cross-sectional image was set to 100 and the densities of the first resin layer and the second resin layer were set to 0, it was confirmed that the density decreased by 25 per nm from the inside of the contrast layer toward the surface.

In addition, the void ratio of the contrast layer was obtained in the same manner as in Example 1, and was found to be less than 5%.

In addition, the surface roughness Ra of the inorganic layer was obtained in the same manner as in Example 1 and was found to be 0.6 nm.

In a case where the evaluation of adhesiveness -1 and the evaluation of adhesiveness -2 were carried out in the same manner as in Example 1 and the like, the maximum load was 12 N/25 mm in both cases.

As can be seen from the foregoing Examples and Comparative Examples, it was found that the laminates manufactured in the Examples were more excellent in the adhesiveness between layers than the laminates manufactured in the Comparative Examples.

The disclosure of JP2022-050807 filed on March 25, 2022 is incorporated herein by reference in its entirety. All documents, patent applications, and technical standards described in the present specification are herein incorporated by reference to the same extent that individual documents, patent applications, and technical standards have been specifically and individually indicated to be incorporated by reference, respectively.

## Claims

1. A laminate comprising:
a first resin layer;
an inorganic layer; and
a second resin layer,
wherein a mixed layer is provided between the first resin layer and the inorganic layer, and between the second resin layer and the inorganic layer.

2. The laminate according to claim 1,
wherein the inorganic layer is a continuous layer.

3. The laminate according to claim 1 or 2,
wherein the inorganic layer has a void ratio of 25% or less.

4. The laminate according to any one of claims 1 to 3,
wherein the mixed layer has a thickness of 1 nm to 30 nm.

5. The laminate according to any one of claims 1 to 4,
wherein the inorganic layer contains one or more inorganic materials selected from the group consisting of a silicon oxide, a silicon nitride, an aluminum oxide, and an aluminum nitride.

6. The laminate according to any one of claims 1 to 5,
wherein the inorganic layer contains silicon dioxide.

7. The laminate according to any one of claims 1 to 6,
wherein the inorganic layer has a thickness of 5 nm or less.

8. A laminate comprising;
a first resin layer; and
a second resin layer,
wherein a contrast layer containing an inorganic material is provided between the first resin layer and the second resin layer, and
in a case where a cross section of the laminate is irradiated with electron beams for 10 minutes under conditions of a voltage of 300 kV using a transmission electron microscope and a cross-sectional image of a test piece after the electron beams irradiation is obtained, a density measured by image analysis software decreases from an inside of the contrast layer of the cross-sectional image toward a surface.

9. A manufacturing method of a laminate, comprising:
a step of forming a mixed layer and an inorganic layer in this order on each surface of a first resin layer and a second resin layer by plasma chemical vapor deposition to obtain a first laminate including the first resin layer, the mixed layer, and the inorganic layer and a second laminate including the second resin layer, the mixed layer, and the inorganic layer; and
a step of laminating the inorganic layer of the first laminate and the inorganic layer of the second laminate.

10. The manufacturing method of a laminate according to claim 9,
wherein the formation of the mixed layer and the inorganic layer on each of the first resin layer and the second resin layer and the lamination of the first laminate and the second laminate are carried out at the same time.

11. The manufacturing method of a laminate according to claim 9 or 10,
wherein the inorganic layer of the first laminate and the inorganic layer of the second laminate each has a surface roughness Ra of 2 nm or less.

12. A manufacturing method of a laminate, comprising:
a step of forming a contrast layer on each surface of a first resin layer and a second resin layer by plasma chemical vapor deposition to obtain a first laminate including the first resin layer and the contrast layer and a second laminate including the second resin layer and the contrast layer; and
a step of laminating the contrast layer of the first laminate and the contrast layer of the second laminate.

13. The manufacturing method of a laminate according to claim 9,
wherein the formation of the contrast layer on each of the first resin layer and the second resin layer and the lamination of the first laminate and the second laminate are carried out at the same time.

14. The manufacturing method of a laminate according to claim 9 or 10,
wherein the contrast layer of the first laminate and the contrast layer of the second laminate each has a surface roughness Ra of 2 nm or less.
